(19) Europäisches Patentamt
European Patent Office
Office européen des brevets

(11) EP 4 787 072 A1

(12) **EUROPEAN PATENT APPLICATION**
published in accordance with Art. 153(4) EPC

(43) Date of publication:
**05.08.2026 Bulletin 2026/32**

(21) Application number: **24871651.6**

(22) Date of filing: **27.08.2024**

(51) International Patent Classification (IPC):
***G03F 7/00*** *(2006.01)* ***B41C 1/05*** *(2006.01)*
***B41N 1/00*** *(2006.01)* ***G03F 7/004*** *(2006.01)*
***G03F 7/11*** *(2006.01)* ***G03F 7/033*** *(2006.01)*
***G03F 7/095*** *(2006.01)*

(52) Cooperative Patent Classification (CPC):
**B41C 1/05; B41N 1/00; G03F 7/00; G03F 7/004; G03F 7/033; G03F 7/095; G03F 7/11**

(86) International application number:
**PCT/JP2024/030369**

(87) International publication number:
**WO 2025/069850 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.09.2023 JP 2023163029**

(71) Applicant: **FUJIFILM Corporation**
**Tokyo 106-8620 (JP)**

(72) Inventor: **SHIRAKAWA, Masato**
**Haibara-gun, Shizuoka 421-0396 (JP)**

(74) Representative: **HGF**
**HGF Limited**
**4th Floor, 1 City Square**
**Leeds LS1 2ES (GB)**

(54) **FLEXOGRAPHIC PRINTING PLATE ORIGINAL PLATE AND METHOD FOR MANUFACTURING FLEXOGRAPHIC PRINTING PLATE**

(57) An object of the present invention is to provide a flexographic printing plate precursor in which microcell reproducibility is favorable in a case of being made into a flexographic printing plate, and a manufacturing method of a flexographic printing plate using the same. A flexographic printing plate precursor includes, in the following order, a support, a photosensitive resin layer, an interlayer, and an infrared ablation layer, in which the photosensitive resin layer contains a base polymer, water-dispersible particles, a photopolymerizable unsaturated compound, and a photopolymerization initiator, and the interlayer contains a copolymer represented by Formula (1).

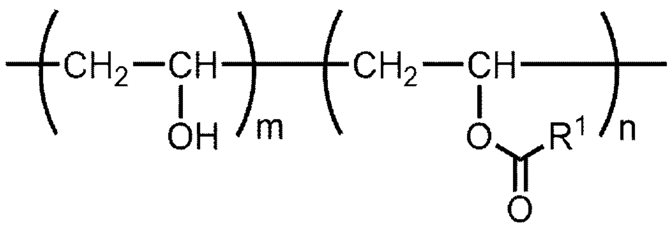

(1)

EP 4 787 072 A1

FIG. 1

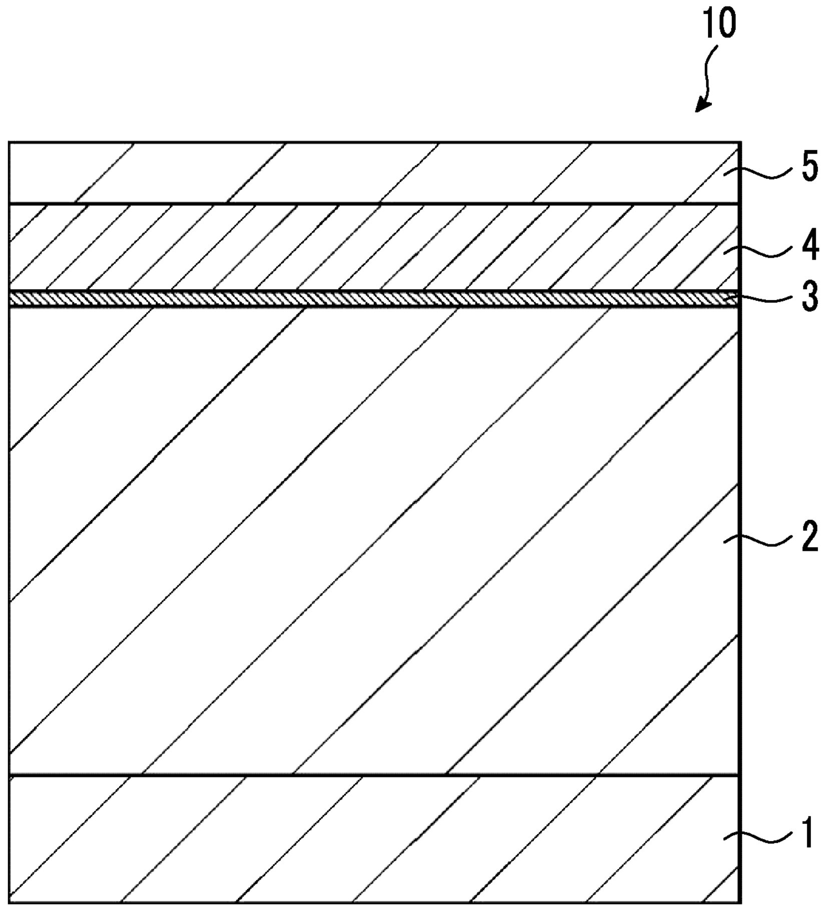

## Description

### BACKGROUND OF THE INVENTION

1. Field of the Invention

The present invention relates to a flexographic printing plate precursor and a manufacturing method of a flexographic printing plate using the same.

2. Description of the Related Art

A precursor of a flexographic printing plate generally includes a photosensitive resin layer (photosensitive layer) formed of a photosensitive resin composition on a support formed of a polyester film or the like. The flexographic printing plate is formed by exposing a surface of the photosensitive resin layer of the precursor to a predetermined image and then removing a resin in a portion not exposed.

In a so-called analog-type flexographic printing plate precursor, a negative film on which the predetermined image is already formed is placed on the photosensitive resin layer, and the predetermined image is exposed on the surface of the photosensitive resin layer through this negative film.

On the other hand, in a laser ablation mask (LAM)-type flexographic printing plate precursor, an infrared ablation layer is provided in advance on the photosensitive resin layer, an infrared laser is used to draw digitized negative image information directly onto the infrared ablation layer to produce a desired negative pattern, and then the predetermined image is exposed on the surface of the photosensitive resin layer through this negative pattern.

As such a LAM-type flexographic printing plate precursor, for example, JP2012-137515A discloses a flexographic printing plate precursor in which a support, a photosensitive resin layer, and an infrared ablation layer containing a binder polymer and an infrared absorbing substance are laminated.

### SUMMARY OF THE INVENTION

From the viewpoint of improving ink transferability in a case of being made into a flexographic printing plate, the present inventor has attempted to form a fine uneven pattern (hereinafter, also abbreviated as "microcell") on a surface of an image portion in a flexographic printing plate for a known flexographic printing plate precursor disclosed in JP2012-137515A and the like, particularly a flexographic printing plate precursor having a photosensitive resin layer containing water-dispersible particles. A flexographic printing plate having a photosensitive resin layer not containing water-dispersible particles is often used for a paper medium application with excellent ink transferability, and it is not necessary to form a microcell.

Specifically, the present inventor has found that, in a case where a "protective layer for preventing oxygen from inhibiting polymerization of photosensitive resin layer" described in WO2009/141930A is provided as an interlayer on an upper layer of the photosensitive resin layer, the microcell reproducibility is slightly improved in a case of being made into a flexographic printing plate, but there is room for improvement.

Therefore, an object of the present invention is to provide a flexographic printing plate precursor in which microcell reproducibility is favorable in a case of being made into a flexographic printing plate, and a manufacturing method of a flexographic printing plate using the same.

As a result of intensive studies to achieve the above object, the present inventor has found that a flexographic printing plate precursor having a support, a predetermined photosensitive resin layer, an interlayer containing a specific polyvinyl alcohol-based copolymer, and an infrared ablation layer in this order has favorable microcell reproducibility in a case of being made into a flexographic printing plate, and has completed the present invention.

That is, the present inventor has found that the above-described object can be achieved by adopting the following configurations.

[1] A flexographic printing plate precursor comprising, in the following order:

a support;
a photosensitive resin layer;
an interlayer; and
an infrared ablation layer,
in which the photosensitive resin layer contains a base polymer, water-dispersible particles, a photopolymerizable unsaturated compound, and a photopolymerization initiator, and
the interlayer contains a copolymer represented by Formula (1).

[2] The flexographic printing plate precursor according to [1], in which the base polymer is a diene-based rubber.

[3] The flexographic printing plate precursor according to [1] or [2], in which a content of the photopolymerization initiator is 1.5% by mass or more and less than 5.0% by mass with respect to a total solid content of the photosensitive resin layer.

[4] The flexographic printing plate precursor according to any one of [1] to [3], in which a content of the water-dispersible particles is 10% by mass or more and less than 50% by mass with respect to a total solid content of the photosensitive resin layer.

[5] The flexographic printing plate precursor according to [2], in which the diene-based rubber is a butadiene rubber.

[6] A manufacturing method of a flexographic printing plate having a non-image area and an image area, the manufacturing method comprising:

a mask forming step of, with respect to the flexographic printing plate precursor according to any one of [1] to [5], forming an image on the infrared ablation layer included in the flexographic printing plate precursor to form a mask;
an exposure step of, after the mask forming step, imagewise exposing the photosensitive resin layer included in the flexographic printing plate precursor through the mask; and
a development step of, after the exposure step, performing development using a developer to form a non-image area and an image area.

According to the present invention, it is possible to provide a flexographic printing plate precursor in which microcell reproducibility is favorable in a case of being made into a flexographic printing plate, and a manufacturing method of a flexographic printing plate using the same.

## BRIEF DESCRIPTION OF THE DRAWINGS

FIG. 1 is a schematic cross-sectional view showing an example of a flexographic printing plate precursor according to the embodiment of the present invention.

## DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments.

In the specification of the present application, the numerical range expressed by using "to" means a range including the numerical values before and after "to" as the lower limit value and the upper limit value.

In addition, in a range of numerical values described in stages in the present specification, the upper limit value or the lower limit value described in a certain range of numerical values may be replaced with an upper limit value or a lower limit value of the range of numerical values described in other stages. In addition, regarding the numerical range described in the present specification, an upper limit value or a lower limit value described in a numerical value may be replaced with a value described in Examples.

In addition, in the present specification, substances corresponding to respective components may be used alone or in combination of two or more kinds thereof. Here, in a case where two or more kinds of substances are used in combination for each component, the content of the component indicates the total content of the substances used in combination, unless otherwise specified.

In addition, in the present specification, "(meth)acryl" denotes "acryl" or "methacryl", and "(meth)acryloyl" denotes "acryloyl" or "methacryloyl".

[Flexographic Printing Plate Precursor]

The flexographic printing plate precursor according to the embodiment of the present invention is a flexographic printing plate precursor having, in the following order, a support, a photosensitive resin layer, an interlayer, and an infrared ablation layer.

In addition, the photosensitive resin layer of the flexographic printing plate precursor according to the embodiment of the present invention contains a base polymer, water-dispersible particles, a photopolymerizable unsaturated compound, and a photopolymerization initiator.

Furthermore, the interlayer of the flexographic printing plate precursor according to the embodiment of the present invention contains a copolymer represented by Formula (1).

FIG. 1 is a schematic cross-sectional view showing an example of the flexographic printing plate precursor according to the embodiment of the present invention.

A flexographic printing plate precursor 10 shown in FIG. 1 includes a support 1, a photosensitive resin layer 2, an interlayer 3, and an infrared ablation layer 4 in this order.

In addition, as shown in FIG. 1, the flexographic printing plate precursor according to the embodiment of the present invention may include a cover sheet 5.

In the present invention, as described above, the flexographic printing plate precursor having a support, a predetermined photosensitive resin layer, an interlayer containing a copolymer represented by Formula (1), and an infrared ablation layer in this order has favorable microcell reproducibility in a case of being made into a flexographic printing plate.

Although the details thereof are not clear, the present inventor has presumed as follows.

First, it can be seen from Comparative Example 3 described later that, in an aspect in which the "protective layer for preventing oxygen from inhibiting polymerization of photosensitive resin layer" described in WO2009/141930A is provided as the interlayer, the microcell reproducibility is poor. It is considered that this is because the degree of saponification of the polyvinyl alcohol-based copolymer contained in the interlayer is high and sufficiently functions as an oxygen blocking layer, but in a case of forming (developing) a fine uneven structure such as a microcell, light leakage from the protrusion portion (exposure portion) or a radical polymerization reaction in the exposure portion (particularly in the vicinity of the boundary with the non-exposure portion) is chained, and the polymerization reaction proceeds even in the recessed portion (non-exposure portion), making it difficult to form the recessed portion. In particular, it is considered that, in an environment where oxygen is blocked, the radical polymerization reaction proceeds easily, and the polymerization reaction proceeds even in the recessed portion (non-exposure portion), and thus the recessed portion is not formed.

Therefore, in the present invention, it is considered that, by using the interlayer containing the copolymer represented by Formula (1) described later, the polymerization reaction in the recessed portion (non-exposure portion) due to light leakage or the chaining of the radical polymerization reaction can be suppressed by allowing a certain amount of oxygen to pass through, and thus the microcell reproducibility is improved.

Hereinafter, each layer configuration included in the flexographic printing plate precursor according to the embodiment of the present invention will be described in detail.

[Support]

A material used for the support included in the flexographic printing plate precursor according to the embodiment of the present invention is not particularly limited, and a support with high dimensional stability is preferably used. Examples thereof include metals such as steel, stainless steel, and aluminum; polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; glass fiber reinforced plastic resin (such as epoxy resin and phenolic resin); and cloth and paper.

From the viewpoint of dimensional stability and availability, the support is preferably a polymer film or cloth, and more preferably a polymer film. The morphology of the support is determined by whether the polymer layer is sheet-like or sleeve-like.

As the cloth, plain or twill weave fabrics and various knitted fabrics of natural fibers such as cotton, linen, silk, and wool or synthetic fibers such as acetate, vinylon, vinylidene, polyvinyl chloride, acrylic, polypropylene, polyethylene, polyurethane, fluorine filament, polyclar, rayon, nylon, polyamide, and polyester, or nonwoven fabrics can be used.

Examples of the polymer film include a film formed of various polymers such as polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; and glass fiber reinforced plastic resin (such as epoxy resin and phenolic resin). Among these, from the viewpoint of dimensional stability and the like, a polyester film is preferable.

Examples of the above-described polyester film include a PET film, a PBT film, and a PEN film, and from the viewpoint of dimensional stability and the like, a polyethylene terephthalate (PET) film is preferable.

A film thickness of the support is not particularly limited, but from the viewpoint of dimensional stability and handleability, it is preferably 5 to 3,000 μm, more preferably 50 to 2,000 μm, and still more preferably 100 to 1,000 μm.

[Photosensitive Resin Layer]

The photosensitive resin layer of the flexographic printing plate precursor according to the embodiment of the present invention contains a base polymer, water-dispersible particles, a photopolymerizable unsaturated compound, and

a photopolymerization initiator.

<Base Polymer>

The base polymer is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polysulfone resin, a polyethersulfone resin, a polyimide resin, an acrylic resin, an acetal resin, an epoxy resin, a polycarbonate resin, rubbers, and a thermoplastic elastomer. These may be used alone or in combination of two or more.

Among these, from the reason that an elastic and flexible film can be easily formed, a rubber or a thermoplastic elastomer is preferable, a rubber is more preferable, and a diene-based rubber is still more preferable.

Specific examples of the above-described diene-based rubber include butadiene rubber (BR), nitrile rubber (NBR), acrylic rubber, epichlorohydrin rubber, urethane rubber, isoprene rubber, styrene isoprene rubber, styrene butadiene rubber (SBR), and ethylene-propylene copolymer. These may be used alone or in combination of two or more.

Among these, from the reason that the microcell reproducibility is more favorable in a case of being made into a flexographic printing plate (hereinafter, also simply referred to as "the effect of the present invention is more excellent"), butadiene rubber is preferable.

A content of the base polymer is preferably 1% to 50% by mass, more preferably 5% to 40% by mass, and still more preferably 7% to 30% by mass with respect to the total solid content of the photosensitive resin layer.

<Water-Dispersible Particles>

The water-dispersible particles are not particularly limited, but from the reason that the effect of the present invention is more excellent, a polymer is preferable.

Specific examples of the above-described polymer include diene-based polymers (for example, polybutadiene, natural rubber, styrene-butadiene copolymer, acrylonitrile-butadiene copolymer, methyl methacrylate-butadiene copolymer, polychloroprene, and polyisoprene), polyurethane, vinylpyridine polymer, butyl polymer, thiokol polymer, acrylate polymer, and a polymer obtained by copolymerizing these polymers with other components such as acrylic acid and methacrylic acid. These may be used alone or in combination of two or more.

In addition, the polymer is preferably a diene-based polymer and more preferably polybutadiene.

Furthermore, it is preferable that the above-described polymer does not have a reactive functional group (for example, a (meth)acryloyloxy group) at both terminals.

The polymer is preferably a polymer obtained by removing water from a water-dispersible latex. Specific examples of the above-described water-dispersible latex include the water-dispersible latex of specific examples of the above-described polymer.

A content of the water-dispersible particles is preferably 5% to 80% by mass, and more preferably 10% by mass or more and less than 50% by mass, and still more preferably 20% to 45% by mass with respect to the total solid content of the photosensitive resin layer, from the reason that the microcell reproducibility is more favorable in a case of being made into a flexographic printing plate and the printing durability is also favorable.

<Photopolymerizable Unsaturated Compound>

The photopolymerizable unsaturated compound is not particularly limited, but may be any of a monofunctional monomer or a polyfunctional monomer, and both may be used in combination, from the reason that the effect of the present invention is more excellent.

(Monofunctional Monomer)

From the reason that the effects of the present invention are more excellent, the monofunctional monomer is preferably a compound having one ethylenically unsaturated group.

Examples of the ethylenically unsaturated group include a radically polymerizable group including a (meth)acryloyl group, a vinyl group, a styryl group, and an allyl group, and among these, a (meth)acryloyl group or $C(O)OCH=CH_2$ is preferable and a (meth)acryloyl group is more preferable.

Examples of the compound having one ethylenically unsaturated group include: N-vinyl compounds such as N-vinylformamide; (meth)acrylamide compounds such as (meth)acrylamide, N-methylol(meth)acrylamide, diacetone(meth)acrylamide, N,N-dimethyl(meth)acrylamide, N,N-diethyl(meth)acrylamide, N-isopropyl(meth)acrylamide, (meth)acryloylmorpholine, and (meth)acrylamide; (meth)acrylate compounds such as 2-hydroxyethyl(meth)acrylate, butoxyethyl(meth)acrylate, carbitol(meth)acrylate, cyclohexyl(meth)acrylate, tetrahydrofurfuryl(meth)acrylate, benzyl(meth)acrylate, tridecyl(meth)acrylate, 2-phenoxyethyl(meth)acrylate, glycidyl(meth)acrylate, isobornyl(meth)acrylate, dicyclopentenyl(meth)acrylate, dicyclopentenyloxyethyl(meth)acrylate, dicyclopentanyl(meth)acrylate, 2-hydroxy-3-phenoxypropyl(meth)acrylate, 2-(meth)acryloyloxyethylphthalic acid, methoxy-polyethylene glycol(meth)acrylate, 2-(meth)acryloyloxyethyl-2-hydroxyethylphthalic acid, 2-(2-ethoxyethoxy)ethyl(meth)acrylate, 2-methoxyethyl(meth)acrylate, 3-methoxybutyl(meth)acrylate, ethoxyphenyl(meth)acrylate, 2-(meth)acryloyloxyethylsuccinic acid, nonylphenol EO adduct(meth)acrylate, phenoxy-polyethylene glycol(meth)acrylate, 2-(meth)acryloyloxyethylhexahydrophthalic acid, lactone-modified(meth)acrylate, stearyl(meth)acrylate, isoamyl(meth)acrylate, isomyristyl(meth)acrylate, isostearyl(meth)acrylate, and cyclic trimethylolpropane formal(meth)acrylate; and monovinyl ether compounds such as methylvinyl ether, ethylvinyl ether, n-propylvinyl ether, isopropylvinyl ether, n-butylvinyl ether, isobutylvinyl ether, t-butylvinyl ether, n-octadecylvinyl ether, 2-ethylhexylvinyl ether, n-nonylvinyl ether, dodecylvinyl ether, octadecylvinyl ether, cyclohexylvinyl ether, cyclohexylmethylvinyl ether, 4-methylcyclohexylmethylvinyl ether, benzylvinyl ether, dicyclopentenylvinyl ether, 2-dicyclopentenoxyethylvinyl ether, methoxyethylvinyl ether, ethoxyethylvinyl ether, butoxyethylvinyl ether, methoxyethoxyethylvinyl ether, ethoxyethoxyethylvinyl ether, methoxypolyethylene glycolvinyl ether, tetrahydrofurfurylvinyl ether, 2-hydroxyethylvinyl ether, 2-hydroxypropylvinyl ether, 4-hydroxybutylvinyl ether, 4-hydroxymethylcyclohexylmethylvinyl ether, diethylene glycol monovinyl ether, polyethylene glycolvinyl ether, chloroethylvinyl ether, chlorobutylvinyl ether, chloroethoxyethylvinyl ether, phenylethylvinyl ether, phenoxy polyethylene glycolvinyl ether, cyclohexanedimethanol monovinyl ether, and isopropenyl ether-O-propylene carbonate.

EO represents ethylene oxide.

From the reason that the effects of the present invention are more excellent, a content of the monofunctional monomer is preferably 0.1% to 30% by mass, and more preferably 1% to 10% by mass with respect to the total solid content in the photosensitive resin layer.

(Polyfunctional Monomer)

From the reason that the effects of the present invention are more excellent, the polyfunctional monomer is preferably a compound having two ethylenically unsaturated groups. Specific examples of the above-described ethylenically unsaturated group are as described above.

Examples of the compound having two ethylenically unsaturated groups include: glycol di(meth)acrylate compounds such as ethylene glycol di(meth)acrylate, diethylene glycol di(meth)acrylate, triethylene glycol di(meth) acrylate, tetraethylene glycol di(meth)acrylate, polyethylene glycol di(meth)acrylate, propylene glycol di(meth)acrylate, dipropylene glycol di(meth)acrylate, tripropylene glycol di(meth)acrylate, tetrapropylene glycol di(meth)acrylate, polypropylene glycol di(meth)acrylate, ethoxylated neopentyl glycol di(meth)acrylate, and propoxylated neopentyl glycol di(meth)acrylate; di(vinyl) ether compounds such as ethylene glycol divinyl ether, diethylene glycol divinyl ether, triethylene glycol divinyl ether, propylene glycol divinyl ether, dipropylene glycol divinyl ether, butanediol divinyl ether, hexanediol divinyl ether, and cyclohexanedimethanol divinyl ether; and bisphenol A di(meth)acrylate compounds such as bisphenol A diglycidyl ether (meth)acrylic acid adduct, modified bisphenol A di(meth)acrylate, bisphenol A PO adduct di(meth)acrylate, and bisphenol A EO adduct di(meth)acrylate.

PO represents propylene oxide and EO represents ethylene oxide.

From the reason that the effect of the present invention is more excellent, a content of the polyfunctional monomer is preferably 0.1% to 30% by mass with respect to the total solid content of the photosensitive resin layer.

<Photopolymerization Initiator>

The photopolymerization initiator is not particularly limited, and examples thereof include photopolymerization initiators such as alkylphenones, acetophenones, benzoin ethers, benzophenones, thioxanthones, anthraquinones, benzyls, and biacetyls.

More specific examples thereof include benzyl dimethyl ketal, 2-hydroxy-2-methyl-1-phenyl-propan-1-one, methyl-o-benzoylbenzoate, and 1-hydroxycyclohexyl phenyl ketone.

A content of the photopolymerization initiator is preferably 0.5% to 10% by mass, and more preferably 1.5% by mass or more and less than 5.0% by mass, and still more preferably 2.5% to 4.5% by mass with respect to the total solid content of the photosensitive resin layer, from the reason that the microcell reproducibility is more favorable in a case of being made into a flexographic printing plate and the printing durability is also favorable.

<Polymerization Inhibitor>

From the reason that the effects of the present invention are more excellent, the photosensitive resin layer preferably contains a polymerization inhibitor (stabilizer).

Examples of the polymerization inhibitor include phenols, hydroquinones, and catechols.

In a case where the photosensitive resin layer contains a polymerization inhibitor, a content of the polymerization inhibitor is preferably 0.01% to 5% by mass, and more preferably 0.01% to 0.5% by mass with respect to the total solid content of the photosensitive resin layer.

<Telechelic Polymer>

From the reason that the effects of the present invention are more excellent, the photosensitive resin layer preferably contains a telechelic polymer.

In the present specification, the "telechelic polymer" means a polymer which has a reactive functional group at both terminals.

(Main Chain)

A polymer constituting a main chain of the telechelic polymer is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer.

Among these, from the reason that more elastic and flexible film can be easily formed, a rubber or a thermoplastic elastomer is preferable, a rubber is more preferable, and a diene-based rubber is still more preferable.

Specific examples of the above-described rubber include butadiene rubber (BR), nitrile rubber (NBR), acrylic rubber, epichlorohydrin rubber, urethane rubber, isoprene rubber, styrene isoprene rubber, styrene butadiene rubber (SBR), ethylene-propylene copolymer, and chlorinated polyethylene. These may be used alone or in combination of two or more. Among these, from the reason that water developability is improved, or from the viewpoint of drying properties and image reproducibility, at least one rubber selected from the group consisting of butadiene rubber (BR), styrene butadiene rubber (SBR), and nitrile rubber (NBR) is preferable, and butadiene rubber or styrene butadiene rubber is more preferable.

Examples of the above-described thermoplastic elastomer include a polybutadiene-based thermoplastic elastomer (PB), a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that water developability is improved, or from the viewpoint of drying properties and image reproducibility, PB, SBS, or SIS is particularly preferable.

(Terminal)

The telechelic polymer has a reactive functional group at both terminals.

The above-described reactive functional group is not particularly limited, but from the reason that the effects of the present invention are more excellent, an ethylenically unsaturated group is preferable.

From the reason that the effects of the present invention are more excellent, the above-described ethylenically unsaturated group is preferably a vinyl group ($CH_2$=CH-), an allyl group ($CH_2$=CH-$CH_2$-), a (meth)acryloyl group, or a (meth)acryloyl group, and more preferably a (meth)acryloyloxy group.

The telechelic polymer may have a reactive functional group at both terminals of the polymer constituting the main chain through a divalent linking group.

The above-described divalent linking group is not particularly limited, and examples thereof include a linear, branched, or cyclic divalent aliphatic hydrocarbon group (for example, an alkylene group such as a methylene group, an ethylene group, and a propylene group), a divalent aromatic hydrocarbon group (for example, a phenylene group), -O-, -S-, -$SO_2$-, -NRL-, -CO-, -NH-, -COO-, -CONRL-, -O-CO-O-, -$SO_3$-, -NHCOO-, -$SO_2$NRL-, -NH-CO-NH-, and a group in which two or more of these groups are combined (for example, an alkyleneoxy group, an alkyleneoxycarbonyl group, an alkylenecarbonyloxy group, and the like). Here, RL represents a hydrogen atom or an alkyl group (preferably having 1 to 10 carbon atoms).

(Molecular Weight)

From the reason that the effects of the present invention are more excellent, a weight-average molecular weight

(Mw) of the telechelic polymer is preferably 6,000 or more, more preferably 7,000 or more, still more preferably 8,000 or more, and particularly preferably 9,000 or more. The upper limit of Mw of the telechelic polymer is not particularly limited, but from the reason that the effects of the present invention are more excellent, it is preferably 500,000 or less and more preferably 100,000 or less.

Here, the weight-average molecular weight is measured by a gel permeation chromatograph method (GPC) and is calculated by converting with standard polystyrene. Specifically, for example, HLC-8220 GPC (manufactured by Tosoh Corporation) is used as GPC, three of TSKgeL SuperHZM-H, TSKgeL SuperHZ4000, and TSKgeL SuperHZ2000 (all manufactured by Tosoh Corporation, 4.6 mmID × 15 cm) are used as a column, and tetrahydrofuran (THF) is used as an eluent. In addition, as the conditions, a sample concentration of 0.35% by mass, a flow rate of 0.35 mL/min, a sample injection amount of 10 μL, and a measurement temperature of 40°C are set, and an IR detector is used. In addition, a calibration curve is created using 8 samples of "F-40", "F-20", "F-4", "F-1", "A-5000", "A-2500", "A-1000", and "n-propylbenzene" which are "Standard Samples TSK standard, polystyrene" (manufactured by TOSOH Corporation).

(HSP Value)

A Hansen solubility parameter (HSP) value of the telechelic polymer is not particularly limited, but from the reason that the effects of the present invention are more excellent, it is preferably 8 to 12, more preferably 8.5 to 11, and still more preferably 8.5 to 10.5.

(Content)

In a case where the photosensitive resin layer contains a telechelic polymer, from the reason that the effect of the present invention is more excellent, a content of the telechelic polymer is preferably 1% to 50% by mass and more preferably 5% to 40% by mass with respect to the total solid content of the photosensitive resin layer.

<Plasticizer>

From the reason that flexibility is further improved, the photosensitive resin layer preferably contains a plasticizer.

Specific examples of the plasticizer include liquid rubber, oil, polyester, and phosphoric acid-based compounds.

Specific examples of the liquid rubber include liquid polybutadiene, liquid polyisoprene, and compounds in which these compounds are modified with maleic acid or an epoxy group.

Specific examples of the oil include paraffin, naphthene, and aroma.

Specific examples of the polyester include adipic acid-based polyester.

Specific examples of the phosphoric acid-based compound include phosphoric acid ester.

In a case where the photosensitive resin layer contains a plasticizer, from the reason that the flexibility is further improved, a content of the plasticizer is preferably 0.1% to 40% by mass and more preferably 5% to 30% by mass with respect to the total solid content of the photosensitive resin layer.

<Surfactant>

From the viewpoint of improving the water developability, the photosensitive resin layer preferably contains a surfactant.

Examples of the surfactant include a cationic surfactant, an anionic surfactant, and a nonionic surfactant. Among these, from the reason that the effects of the present invention are more excellent, an anionic surfactant is preferable.

Specific examples of the anionic surfactant include

aliphatic carboxylates such as sodium laurate, and sodium oleate;
higher alcohol sulfate salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkylaryl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate

monoester, and sodium polyoxyethylene lauryl ether phosphate diester;
and the like. These may be used alone or in combination of two or more.

Among these, from the reason that the water developability is improved, sulfonic acid-based surfactants such as alkyl sulfonate and alkyl allyl sulfonate are preferable.
In a case where the photosensitive resin layer contains a surfactant, from the viewpoint of developability and drying properties after development, a content of the surfactant is preferably 0.1% to 20% by mass and more preferably 1% to 10% by mass with respect to the total solid content of the photosensitive resin layer.

<Other Additives>

To the extent that the effects of the present invention are not impaired, other additives such as an ultraviolet absorber, a dye, a pigment, an anti-foaming agent, and a fragrance can be appropriately further added to the photosensitive resin layer, for the purpose of improving various properties.

<Method for Producing Photosensitive Resin Layer>

A method for producing the photosensitive resin layer is not particularly limited, and examples thereof include a method of preparing a resin composition containing each of the above-described components and applying the resin composition to the above-described support.
A film thickness of the photosensitive resin layer is preferably 0.01 to 10 mm and more preferably 0.2 to 6 mm.

[Interlayer]

<Copolymer>

The interlayer of the flexographic printing plate precursor according to the embodiment of the present invention is a layer containing a copolymer represented by Formula (1).

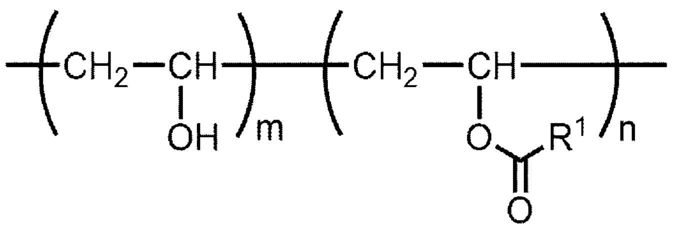 (1)

In Formula (1), $R^1$ represents an alkyl group having 1 to 6 carbon atoms.
Examples of the alkyl group having 1 to 6 carbon atoms include a methyl group, an ethyl group, a propyl group, an isopropyl group, an n-butyl group, an isobutyl group, a sec-butyl group, a tert-butyl group, an n-pentyl group, and an n-hexyl group.
Among these, a methyl group is preferable.
In the following, the copolymer in which $R^1$ in Formula (1) is represented by a methyl group is also referred to as "partially saponified polyvinyl acetate".
In Formula (1), m and n represent contents (% by mole) of each repeating unit, and a molar ratio represented by Formula (i) satisfies 60 to 75% by mole. In the following, the molar ratio represented by Formula (i) is also simply referred to as a "molar ratio".

$$m/(m + n) \times 100 \qquad (i)$$

The molar ratio represented by Formula (i) can be measured by a diffuse reflection method.
Here, the diffuse reflection method is a method of obtaining a near-infrared absorption spectrum by diffusely reflecting measurement light on a sample surface in a case where the measurement light reaches a light-receiving unit from a light-emitting unit of a near-infrared analysis device.
In a case where the measurement by the diffuse reflection method is performed at, for example, a temperature of room temperature, a measurement wavelength of 4,000 $cm^{-1}$ to 12,000 $cm^{-1}$, a resolution of 8 $cm^{-1}$, and an integration

number of 64 times, the molar ratio can be measured in a measurement time of about 1 minute.

Specifically, first, a near-infrared absorption spectrum of a plurality of polyvinyl alcohol (PVA)-based copolymer samples in which the molar ratio is specified by chemical analysis such as a titration method is measured, and a calibration curve for comparing the molar ratio with the chart of the PVA-based copolymer sample is prepared in advance by multiple regression analysis, principal component regression analysis, partial least squares method, or the like from the measurement result.

Next, the near-infrared absorption spectrum of the sample of the interlayer to be measured is measured, and the molar ratio is determined from the calibration curve prepared in advance.

The near-infrared spectrophotometric analysis device is not particularly limited as long as it is equipped with a multivariate analysis device, and examples thereof include "Vector22/N (trade name)" manufactured by Bruker Optik GmbH, "Antaris (trade name)" manufactured by Nicolet CZ, "Spectrum One NTS (trade name)" manufactured by PerkinElmer, Inc., and "NIRlex (trade name)" manufactured by BUCHI.

In addition, in a case where two or more kinds of the copolymers represented by Formula (1) are contained, the molar ratio can be calculated by adding the molar ratio of each copolymer multiplied by a mass ratio of each copolymer.

On the other hand, since the molar ratio represented by Formula (i) can also be referred to as the degree of saponification of the modified PVA, which is the copolymer represented by Formula (1), it can also be measured by a titration method according to JIS K 6726 (1994).

From the reason that the microcell reproducibility is more favorable in a case of being made into a flexographic printing plate and the printing durability is also favorable, the molar ratio represented by Formula (i) is preferably 65 to 75% by mole and more preferably 70 to 75% by mole.

A weight-average molecular weight of the copolymer represented by Formula (1) is preferably 10,000 to 200,000.

Here, the weight-average molecular weight can be determined by gel permeation chromatography (GPC) measurement.

More specifically, the weight-average molecular weight can be measured under conditions of a column temperature of 40°C and a flow rate of 0.7 mL/min using a gel permeation chromatography-multi-angle light scattering photometer manufactured by Wyatt Technology. As a standard sample, polyethylene oxide and polyethylene glycol are used.

A content of the copolymer represented by Formula (1) is preferably more than 50% by mass, more preferably 55% to 95% by mass, and still more preferably 60% to 90% by mass with respect to the total solid content of the interlayer.

<Plasticizer>

From the reason that flexibility is improved, the interlayer preferably contains a plasticizer.

Here, examples of the plasticizer include the same plasticizers as the optional components described as the plasticizers in the photosensitive resin layer.

In a case where the interlayer contains a plasticizer, from the reason that the flexibility is further improved, a content of the plasticizer is preferably 5% to 45% by mass and more preferably 10% to 40% by mass with respect to the total solid content of the interlayer.

<Method for Producing Interlayer>

A method for producing the interlayer is not particularly limited, and examples thereof include a method of preparing a composition containing each of the above-described components and applying the composition to the above-described photosensitive resin layer.

A film thickness of the interlayer is preferably 0.1 to 6 μm and more preferably 0.2 to 3 μm.

[Infrared Ablation Layer]

The infrared ablation layer included in the flexographic printing plate precursor according to the embodiment of the present invention is a portion serving as a mask which covers the surface of the interlayer.

In addition, the infrared ablation layer is a portion which can be removed by an infrared laser, and the unremoved portion shields (absorbs) ultraviolet light to mask the interlayer and the photosensitive resin layer below the unremoved portion from not being irradiated with the ultraviolet light.

Such an infrared ablation layer can be formed using a resin composition containing a binder polymer and an infrared absorbing substance.

<Binder Polymer>

Examples of the binder polymer contained in the resin composition include a rubber component and a resin component.
Specific examples of the rubber component include butadiene rubber (BR), acrylonitrile butadiene rubber (NBR), acrylic rubber, epichlorohydrin rubber, urethane rubber, isoprene rubber (IR), styrene isoprene rubber (SIR), styrene butadiene rubber (SBR), ethylene-propylene copolymer, and chlorinated polyethylene. These may be used alone or in combination of two or more.
In addition, specific examples of the resin component include a (meth)acrylic resin, a polystyrene resin, a polyester resin, a polyamide resin, a polysulfone resin, a polyethersulfone resin, a polyimide resin, an acrylic resin, an acetal resin, an epoxy resin, and a polycarbonate resin.
Among these, as the polymer component corresponding to the rubber component, butadiene rubber (BR), acrylonitrile butadiene rubber (NBR), or styrene butadiene rubber (SBR) is preferable, and acrylonitrile butadiene rubber (NBR) is more preferable.
In addition, as the polymer component corresponding to the resin component, a (meth)acrylic resin is preferable.

<Infrared Absorbing Substance>

The infrared absorbing substance contained in the resin composition is not particularly limited as long as it is a substance which can absorb infrared rays and convert the infrared rays into heat.
Specific examples of the infrared absorbing substance include black pigments (for example, carbon black, aniline black, cyanine black, and the like), green pigments (for example, phthalocyanine, naphthalocyanine, and the like), rhodamine coloring agents, naphthoquinone-based coloring agents, polymethine dyes, diimmonium salts, azoimonium-based coloring agents, chalcogen-based coloring agents, carbon graphite, iron powder, diamine-based metal complexes, dithiol-based metal complexes, phenolthiol-based metal complexes, mercaptophenol-based metal complexes, aryl aluminum metal salts, crystal water-containing inorganic compounds, copper sulfate, metal oxides (for example, cobalt oxide, tungsten oxide, and the like), and metal powders (for example, bismuth, tin, tellurium, aluminum, and the like).
Among these, from the viewpoint of having an ultraviolet absorbing function and the like, carbon black, carbon graphite, or the like is preferable.
The infrared ablation layer may contain various additives in addition to the binder polymer and the infrared absorbing substance described above.
Examples of such as additive include a surfactant, a plasticizer, an ultraviolet absorbing substance, a mold release agent, a dye, a pigment, an antifoaming agent, and a fragrance.
A method for producing the infrared ablation layer is not particularly limited, and examples thereof include a method of preparing a resin composition containing each of the above-described components and applying the resin composition to the above-described interlayer.
A film thickness of the infrared ablation layer is preferably 0.1 to 6 μm and more preferably 0.5 to 3 μm.

[Cover Sheet]

As shown in FIG. 1, the flexographic printing plate precursor according to the embodiment of the present invention may include a cover sheet.
Such a cover sheet is not particularly limited, but is preferably a transparent polymer film and may be one layer alone or two or more layers laminated.
Here, the "transparent" in the present invention means that a transmittance of visible light is 60% or more, preferably 80% or more and particularly preferably 90% or more.
Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate, polyethylene naphthalate, and a fluoropolyester polymer; styrene-based polymers such as polystyrene and an acrylonitrile-styrene copolymer (AS resin); polyolefin-based polymers such as polyethylene, polypropylene, an ethylene-propylene copolymer, and polybutadiene; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.
In addition, a surface (surface on which the infrared ablation layer is formed) of the cover sheet may be subjected to peeling treatment for suppressing adhesion of the infrared ablation layer and enhancing peelability of the cover sheet.

Examples of such a peeling treatment include a method of applying a peeling agent to the surface of the cover sheet to form a peeling layer. Examples of the peeling agent include a silicone-based peeling agent and an alkyl-based peeling agent.
A film thickness of the cover sheet is preferably 25 to 250 μm.

[Manufacturing Method of Flexographic Printing Plate]

The manufacturing method of a flexographic printing plate according to the embodiment of the present invention is a manufacturing method of a flexographic printing plate having a non-image area and an image area, the manufacturing method including:

a mask forming step of forming an image on the infrared ablation layer included in the above-described flexographic printing plate precursor according to the embodiment of the present invention to form a mask;
an exposure step of, after the mask forming step, imagewise exposing the photosensitive resin layer included in the above-described flexographic printing plate precursor according to the embodiment of the present invention through the mask; and
a development step of, after the above-described exposure step, performing development using a developer to form a non-image area and an image area.

[Mask Forming Step]

The above-described mask forming step is a step of forming an image on the infrared ablation layer to form a mask to be used in the exposure step described later.
Here, in the infrared ablation layer, in a case of being irradiated with an infrared laser, the action of the infrared absorbing substance generates heat, which decomposes the infrared ablation layer to be removed, that is, to laser-ablate the infrared ablation layer.
Therefore, by selectively laser-ablating the infrared ablation layer based on the image data, it is possible to obtain an image mask capable of forming a latent image on the photosensitive resin layer.
For the infrared laser irradiation, an infrared laser having an oscillation wavelength in a range of 750 nm to 3000 nm is used.
Examples of such a laser include a solid-state laser such as a ruby laser, an Alexandrite laser, a perovskite laser, an Nd-YAG laser, and an emerald glass laser; a semiconductor laser such as InGaAsP, InGaAs, and GaAsAl; and a coloring agent laser such as a Rhodamine coloring agent.
In addition, a fiber laser which amplifies these light sources with a fiber can also be used.
Among these, from the reason that the sensitivity of the infrared ablation layer is increased, it is preferable to use an exposure light source having an oscillation wavelength of 900 to 1200 nm, and it is more preferable to use a fiber laser.

[Exposure Step]

The above-described exposure step is a step of imagewise exposing the photosensitive resin layer through the mask obtained in the above-described mask forming step, and by imagewise irradiating the photosensitive resin layer with ultraviolet rays, crosslinking and/or polymerization of regions irradiated with the ultraviolet rays can be induced to be cured.

[Development Step]

The above-described development step is a step of performing development using a developer to form a non-image area and an image area.
The developer used in the above-described development step is not particularly limited, and known developer in the related art can be used. However, from the viewpoint of reducing the environmental load, it is preferable to use a developer containing 50% by mass or more of water (hereinafter, also abbreviated as "aqueous developer"). The developer may be an aqueous solution or a suspension (for example, an aqueous dispersion liquid).
In addition, a content of water contained in the aqueous developer is preferably 80% to 99.99% by mass and more preferably 90% to 99.9% by mass with respect to the total mass of the aqueous developer.

[Rinsing Step]

It is preferable that the manufacturing method of a flexographic printing plate according to the embodiment of the present invention includes a rinsing step of, after the above-described development step, rinsing surfaces of the non-image area and the image area formed in the above-described development step with water.

As a rinsing method in the rinsing step, a method of washing with tap water, a method of spraying high pressure water, a method of rubbing the surfaces of the non-image area and the image area with a brush using a known batch-type or transport-type brush-type washing machine as a developing machine for flexographic printing plates mainly in the presence of water, and the like may be used.

[Examples]

Hereinafter, the present invention will be described in more detail with reference to Examples. Materials, amounts used, ratios, treatment contents, treatment procedures, and the like shown in the following examples can be appropriately changed without departing from the spirit of the present invention. Therefore, the scope of the present invention should not be limitatively interpreted by the following examples.

[Synthesis of Partially Saponified Polyvinyl Acetate A (Molar Ratio: 63%)]

The partially saponified polyvinyl acetate A was synthesized as follows.
50 parts by mass of vinyl acetate and 60 parts by mass of methanol were polymerized under nitrogen substitution at 60°C, and cooled to stop the polymerization at a point in time when the degree of polymerization reached 500.
Next, unreacted vinyl acetate was removed to obtain a methanol solution of polyvinyl acetate.
By adding a NaOH methanol solution (10% concentration) to the obtained solution to deacetylate the polyvinyl acetate, partially saponified polyvinyl acetate A (degree of polymerization: 500) was obtained in which $R^1$ in Formula (1) was represented by a methyl group and the molar ratio represented by Formula (i) was 63% by mole.

[Synthesis of Partially Saponified Polyvinyl Acetate B (Molar Ratio: 50%)]

The partially saponified polyvinyl acetate B was synthesized as follows.
50 parts by mass of vinyl acetate and 60 parts by mass of methanol were polymerized under nitrogen substitution at 60°C, and cooled to stop the polymerization at a point in time when the degree of polymerization reached 500.
Next, unreacted vinyl acetate was removed to obtain a methanol solution of polyvinyl acetate.
By adding a NaOH methanol solution (7% concentration) to the obtained solution to deacetylate the polyvinyl acetate, partially saponified polyvinyl acetate B (degree of polymerization: 500) was obtained in which $R^1$ in Formula (1) was represented by a methyl group and the molar ratio represented by Formula (i) was 50% by mole.

[Example 1]

[Preparation of Composition for Forming Infrared Ablation Layer]

100 parts by mass of carbon black and 3 parts by mass of a plasticizer were added to 100 parts by mass of a binder polymer consisting of 50 parts by mass of an acrylic resin A (Hi-pearl M5000, Tg: 65°C, manufactured by Negami Chemical Industrial Co., Ltd.) and 50 parts by mass of NBR, and 812 parts by mass of methyl isobutyl ketone as a solvent was further added thereto, the mixture was mixed by stirring blades. The obtained mixed solution was dispersed using a three-roll mill, and then methyl isobutyl ketone was further added thereto so that the solid content was 15% by mass to prepare a composition for forming an infrared ablation layer.

[Preparation of Composition for Forming Interlayer]

The partially saponified polyvinyl acetate (GOHSENOL NK-05R, molar ratio: 71 to 75, manufactured by Mitsubishi Chemical Corporation) and the plasticizer (Sanflex SE270, manufactured by Sanyo Chemical Industries, Ltd., aliphatic polyhydric alcohol-based polyether polyol, concentration of solid contents: 85%) were mixed at a mass ratio of 65/35 to obtain a composition for forming an interlayer.

[Preparation of Composition for Forming Photosensitive Resin Layer]

63.6 parts by mass of a water-dispersible latex (Nipol LX111NF, water-dispersible latex of polybutadiene, solid content: 55%, manufactured by Zeon Corporation), 10 parts by mass of a telechelic polymer (BAC-45, manufactured by Osaka Organic Chemical Industry Ltd.; polybutadiene having acryloyloxy groups at both terminals, Mw = 10,000), and 12 parts by mass of 1,9-nonanediol dimethacrylate (NK ESTER NOD-N, manufactured by SHIN-NAKAMURA CHEMICAL Co., Ltd.) were mixed with each other, and moisture was evaporated for 3 hours in a dryer heated to 60°C to obtain a mixture containing water-dispersible particles.

The mixture, 20 parts by mass of butadiene rubber (NF35R, manufactured by Asahi Kasei Corporation), 16 parts by mass of a plasticizer (Diana Process Oil PW-32, manufactured by Idemitsu Kosan Co., Ltd.), and 4.3 parts by mass of a surfactant (RAPISOL A-90, effective content: 90%, manufactured by NOF Corporation) were kneaded in a kneader set at 110°C for 45 minutes.

Thereafter, 0.1 parts by mass of butylhydroxytoluene (BHT) as a thermal polymerization inhibitor and 3.5 parts by mass of Irgacure 651 as a photopolymerization initiator were put into the kneader, and the mixture was kneaded for 5 minutes to obtain a composition for a photosensitive resin layer.

[Production of Flexographic Printing Plate Precursor]

The composition for forming an infrared ablation layer prepared as described above was applied onto a PET film (cover sheet) having a thickness of 125 μm, on which a silicone-based release agent was applied, with a bar coater such that the thickness of the coating film after drying was 1 μm, and dried at 120°C for 5 minutes to obtain a laminate X consisting of an infrared ablation layer/cover sheet.

Next, the composition for forming an interlayer prepared as described above was applied onto a PET film (cover sheet) having a thickness of 125 μm, on which a silicone-based release agent was applied, with a bar coater such that the thickness of the coating film after drying was 1 μm, and dried at 120°C for 5 minutes to obtain a laminate Y consisting of an interlayer/cover sheet.

Next, a surface of the laminate X on which the infrared ablation layer is formed and a surface of the laminate Y on which the interlayer is formed were laminated together, and then pressed with a press machine heated to 120°C so that a thickness was 2 μm to obtain a laminate Z in which the cover sheet, the infrared ablation layer, the interlayer, and the cover sheet were laminated in this order.

Next, the cover sheet on the surface of the interlayer of the laminate Z was peeled off to obtain a laminate A in which a cover sheet, an infrared ablation layer, and an interlayer were laminated in this order.

Next, An adhesive was applied to one side of a PET film (support) having a thickness of 125 μm to form an adhesive layer on the support.

Then, the composition for forming a photosensitive layer prepared as described above was interposed between the adhesive layer on the support and the interlayer of the laminate A, and the interposed composition was pressed with a press machine heated to 120°C such that the thickness of the photosensitive resin layer was 1.5 mm, thereby producing a flexographic printing plate precursor of Example 1 in which a support, an adhesive layer, a photosensitive resin layer, an interlayer, an infrared ablation layer, and a cover sheet were laminated in this order.

[Production of Flexographic Printing Plate]

A flexographic printing plate was produced using the obtained flexographic printing plate precursor according to the following procedure.

It is noted that devices and the like used in each step were as follows.

<Device and the like>

· Imaging machine: CDI Spark 4835 Inline (manufactured by Esko-Graphics BV.)
· Ultraviolet exposure machine Concept: 302 ECDLF (product name) (manufactured by Glunz & Jensen)
· Washing machine: C-Touch 2530 Water Wash Plate Processor (manufactured by GS Trading Co., Ltd.)
· Washing solution: aqueous solution of FINISH POWER & PURE POWDER SP (manufactured by Reckitt Benckiser Japan Ltd.) (concentration: 0.5% by mass)

(1) Back Exposure Step

Back exposure was performed by exposing a back surface of the flexographic printing plate precursor to an energy of 80 W for 10 seconds using the above-described ultraviolet exposure machine.

(2) Mask Forming Step

Next, the cover sheet was peeled off, and the photosensitive resin layer was imaged by ablation using the imaging machine.

As the image, a 100% solid image having a width of 1 cm and a length of 1 cm was used in the same manner as a

2% halftone image having a width of 1 cm and a length of 1 cm.

More specifically, the image was RIPed under conditions of a resolution of 4,000 dpi and a line number of 175 lpi using RIP software Automation Engine Pilot. In addition, an MCWSI pattern, which was a microcell pattern, was applied to the 100% solid image.

(3) Exposure Step

The main exposure was performed by exposing a front surface (reverse surface of the back surface) at 80 W for 360 seconds using the above-described ultraviolet exposure machine.

(4) Development Step

Next, the photosensitive resin layer was developed for 12 minutes using the washing machine and the washing solution.

(5) Drying Step

Next, the obtained product was dried with hot air of 60°C until the moisture was removed.

(6) Post-Exposure Step

Next, the photosensitive resin layer was exposed (post-exposed) to ultraviolet rays for 180 seconds from the photosensitive resin layer side using the ultraviolet exposure machine. In this manner, a flexographic printing plate having an image portion was produced.

[Examples 2 to 10 and Comparative Examples 1 to 4]

A flexographic printing plate precursor and a flexographic printing plate were produced according to the same procedure as in Example 1, except that the kind and content (% by mass) of each component in the interlayer and the photosensitive resin layer were changed as shown in Tables 1 and 2.

Here, in Example 10, as shown in Table 2, since 48.8 parts by mass of partially saponified polyvinyl acetate (GOHSENOL KL-03, molar ratio: 78.5 to 82, manufactured by Mitsubishi Chemical Corporation) and 16.2 parts by mass of partially saponified polyvinyl acetate B (synthesized product described above, molar ratio: 50) were used in combination, the molar ratio represented by Formula (i) can be calculated by adding the molar ratio of each copolymer multiplied by the mass ratio to 71.4 to 74.0% by mole. It is noted that this value could also be confirmed by a titration method according to JIS K 6726 (1994).

[Evaluation]

[Microcell Reproducibility]

The obtained flexographic printing plate was evaluated for microcell reproducibility by the following method.

First, using a hybrid laser microscope OPTELICS (registered trademark) HYBRIDE (manufactured by Lasertec Corporation), a confocal measurement was performed on a surface of the solid image area of the flexographic printing plate in increments of 0.1 μm in height with a 50x Apo objective lens (high numerical aperture (high NA)) to obtain three-dimensional data. An evaluation range was defined as a region of 300 μm in length and 300 μm in width.

From the observation image based on the above-described three-dimensional data, 100 or more convex portions were observed, and the number of reproduced portions without chipping was calculated.

Next, an image reproduction% was calculated by the following expression.

Image reproduction% = (Number of reproduced convex portions without chipping)/(Number of evaluations) × 100

The evaluation was performed using the following standards. The results are shown in Tables 1 and 2 below.

In order to obtain a printed article having a higher solid density, the image reproduction of the microcells is preferably C to A, more preferably B or A, and still more preferably A. In a case where the image reproduction was less than 80%, unevenness of the ink transferred to the printed article was large, and the solid density was deteriorated.

<Evaluation Standard>

A: image reproduction was 98% or more.
B: image reproduction was 90% or more and less than 98%.
C: image reproduction was 80% or more and less than 90%.
D: image reproduction was 70% or more and less than 80%.
E: image reproduction was less than 70%

[Printing Durability]

Printing durability of the obtained flexographic printing plate was evaluated by the following method.

A flexographic printing machine (manufactured by TAIYO KIKAI Ltd., TLF-270) was used as a printing machine. The obtained flexographic printing plate was attached to a plate cylinder (drum) through a cushion tape (manufactured by Lohmann), and installed in the printing machine. Thereafter, a kiss-touch (printing pressure at which the entire surface of the image started to be inked) was set to 0 (reference printing pressure), and from there, printing was performed at a printing speed of 150 m/min under the condition of pushing in 80 μm. A printed material used for the evaluation was sampled up to 25 km every 5 km under the above-described conditions. As the printed material, Aurora Coat 84.9 g/$m^2$ (manufactured by Nippon Paper Industries Co., Ltd.) was used. In addition, as an ink, water-based flexo ink HYDRIC FCF (manufactured by Dainichiseika Color & Chemicals Mfg.Co.,Ltd.) was used.

The number of chippings in a 2% halftone dot image area in the printed material was measured. A printing distance in which 25 of 4746 halftone dots were chipped at the start was set as an end point, and a distance to the end point was evaluated according to the following standard.

The results are shown in Tables 1 and 2 below. Practically, C to A are preferable, B or A is more preferable, and A is still more preferable.

<Evaluation Standard>

A: 25 km or more
B: 20 km or more and less than 25 km
C: 15 km or more and less than 20 km
D: 10 km or more and less than 15 km
E: less than 10 km

[Table 1]

| Table 1 | Material | Product name | Manufacturer | Molar ratio (% by mole) m/(n + m) × 100 | Example | | | | | | |
|---|---|---|---|---|---|---|---|---|---|---|---|
| | | | | | 1 | 2 | 3 | 4 | 5 | 6 | 7 |
| Interlayer | Partially saponified polyvinyl acetate | GOHSENOL NK-05R | Mitsubishi Chemical Corporation | 71-75 | 65 | 65 | 65 | 65 | 65 | 65 | |
| | | Kuraray Poval L-8 | Kuraray Co., Ltd. | 69.5-72. 5 | | | | | | | 65 |
| | | GOHSENOL KL-03 | Mitsubishi Chemical Corporation | 78.5-82 | | | | | | | |
| | | GOHSENOL KH-20 | Mitsubishi Chemical Corporation | 78.5-82 | | | | | | | |
| | | partially saponified polyvinyl acetate A | Synthesized product | 63 | | | | | | | |
| | | partially saponified polyvinyl acetate B | Synthesized product | 50 | | | | | | | |
| | Plasticizer | Sanflex SE270 | Sanyo Chemical Industries, Ltd. | | 35 | 35 | 35 | 35 | 35 | 35 | 35 |

(continued)

| Table 1 | Material | Product name | Manufacturer | Molar ratio (% by mole) m/(n + m) × 100 | Example | | | | | | |
|---|---|---|---|---|---|---|---|---|---|---|---|
| | | | | | 1 | 2 | 3 | 4 | 5 | 6 | 7 |
| Photosensitive resin layer | Base polymer | NF35R (Butadiene rubber) | Asahi Kasei Corporation | | 20 | 10 | 20 | 20 | 20 | 20 | 20 |
| | | D-KX405 (Styrene-butadie ne copolymer) | Kraton Corporation | | | | | | | | |
| | Water-dispersible particle | Nipol LX111NF (Solid content: 55%) | Zeon Corporation | | 63.6 (Solid content : 35. 0%) | 92.7 (Solid content : 51. 0%) | 63.6 (Solid content : 35. 0%) | 63.6 (Solid content : 35. 0%) | 63.6 (Solid content : 35. 0%) | 63.6 (Solid content : 35. 0%) | 63.6 (Solid content : 35. 0%) |
| | Photopolymerizable unsaturated compound | NK ESTER NOD-N | KYOEISH A CHMICAL Co., Ltd. | | 12 | 12 | 12 | 12 | 12 | 12 | 12 |
| | Photopolymerization initiator | Benzyl dimethyl ketal | Tokyo Chemical Industry Co., Ltd. | | 3.5 | 3.5 | 1.4 | 1.6 | 4.9 | 5.1 | 3.5 |
| | Telechelic polymer | BAC-45 | Osaka Organic Chemical Industry Ltd. | | 10 | 5 | 10 | 10 | 10 | 10 | 10 |
| | Plasticizer | Diana Process Oil PW-32 | Idemitsu Kosan Co., Ltd. | | 16 | 15 | 18 | 18 | 14.6 | 14.4 | 16 |
| | Surfactant | RAPISOL A-90 | NOF Corporation | | 4.3 | 4.3 | 4.4 | 4.2 | 4.3 | 4.3 | 4.3 |
| | Polymerization inhibitor | BHT | | | 0.1 | 0.1 | 0.1 | 0.1 | 0.1 | 0.1 | 0.1 |
| Evaluation | Microcell reproducibility | | | | A | B | C | B | B | C | B |
| | Printing durability | | | | A | B | C | B | A | A | B |

[Table 2]

| Table 2 | Material | Product name | Manufactur er | Molar ratio (% by mole) m/(n + m) × 100 | Example | | | Comparative Example | | | |
|---|---|---|---|---|---|---|---|---|---|---|---|
| | | | | | 8 | 9 | 10 | 1 | 2 | 3 | 4 |
| Interlayer | Partially saponified polyvinyl acetate | GOHSENOL NK-05R | Mitsubishi Chemical Corporation | 71-75 | 65 | | | None | | | |
| | | Kuraray Poval L-8 | Kuraray Co., Ltd. | 69.5-72. 5 | | | | | | | |
| | | GOHSENOL KL-03 | Mitsubishi Chemical Corporation | 78.5-82 | | | 48.8 | | 65 | | |
| | | GOHSENOL KH-20 | Mitsubishi Chemical Corporation | 78.5-82 | | | | | | 65 | |
| | | partially saponified polyvinyl acetate A | Synthesized product | 63 | | 65 | | | | | |
| | | partially saponified polyvinyl acetate B | Synthesized product | 50 | | | 16.2 | | | | 65 |
| | Plasticizer | Sanflex SE270 | Sanyo Chemical Industries, Ltd. | | 35 | 35 | 35 | | 35 | 35 | 35 |

(continued)

| Table 2 | Material | Product name | Manufactur er | Molar ratio (% by mole) m/(n + m) × 100 | Example 8 | Example 9 | Example 10 | Comparative Example 1 | Comparative Example 2 | Comparative Example 3 | Comparative Example 4 |
|---|---|---|---|---|---|---|---|---|---|---|---|
| Photosensitive resin layer | Base polymer | NF35R (Butadiene rubber) | Asahi Kasei Corporation | |  | 20 | 20 | 20 | 20 | 20 | 20 |
| | | D-KX405 (Styrene-butadie ne copolymer) | Kraton Corporation | | 20 | | | | | | |
| | Water-dispersible particle | Nipol LXI11NF (Solid content: 55%) | Zeon Corporation | | 63.6 (Solid content : 35. 0%) | 63.6 (Solid content : 35. 0%) | 63.6 (Solid content : 35. 0%) | 63.6 (Solid content : 35. 0%) | 63.6 (Solid content : 35. 0%) | 63.6 (Solid content : 35. 0%) | 63.6 (Solid content : 35. 0%) |
| | Photopolymerizable unsaturated compound | NK ESTER NOD-N | KYOEISH A CHMICAL Co., Ltd. | | 12 | 12 | 12 | 12 | 12 | 12 | 12 |
| | Photopolymerization initiator | Benzyl dimethyl ketal | Tokyo Chemical Industry Co., Ltd. | | 3.5 | 3.5 | 3.5 | 3.5 | 3.5 | 3.5 | 3.5 |
| | Telechelic polymer | BAC-45 | Osaka Organic Chemical Industry Ltd. | | 10 | 10 | 10 | 10 | 10 | 10 | 10 |
| | Plasticizer | Diana Process Oil PW-32 | Idemitsu Kosan Co., Ltd. | | 16 | 16 | 16 | 16 | 16 | 16 | 16 |
| | Surfactant | RAPISOL A-90 | NOF Corporation | | 4.3 | 4.3 | 4.3 | 4.3 | 4.3 | 4.3 | 4.3 |
| | Polymerization inhibitor | BHT | | | 0.1 | 0.1 | 0.1 | 0.1 | 0.1 | 0.1 | 0.1 |
| Evaluation | Microcell reproducibility | | | | B | C | A | E | D | D | E |
| | Printing durability | | | | A | C | A | C | A | A | C |

From the results shown in Tables 1 and 2, it was found that, in a case where the interlayer was not provided, the microcell reproducibility was poor in a case of being made into a flexographic printing plate (Comparative Example 1).

In addition, it was found that, even in a case where the copolymer represented by Formula (1) was used in the interlayer, the microcell reproducibility was poor in a case of being made into a flexographic printing plate in a case where the molar ratio represented by Formula (i) was more than 75% by mole (Comparative Examples 2 and 3).

In addition, it was found that, even in a case where the copolymer represented by Formula (1) was used in the interlayer, the microcell reproducibility was poor in a case of being made into a flexographic printing plate in a case where the molar ratio represented by Formula (i) was less than 60% by mole (Comparative Example 4).

On the other hand, it was found that, in a case where the copolymer represented by Formula (1) and having the molar ratio represented by Formula (i) of 60 to 75% by mole was used in the interlayer, the microcell reproducibility was favorable in a case of being made into a flexographic printing plate (Examples 1 to 10).

In particular, from the comparison between Example 1 and Example 2, it was found that, in a case where the content of the water-dispersible particles was 10% by mass or more and less than 50% by mass with respect to the total solid content of the photosensitive resin layer, the microcell reproducibility was more favorable in a case of being made into a flexographic printing plate, and the scratch resistance was also favorable.

In addition, from the comparison between Example 1 and Examples 3 to 6, it was found that, in a case where the content of the photopolymerization initiator was 1.5% by mass or more and less than 5.0% by mass with respect to the total solid content of the photosensitive resin layer, the microcell reproducibility was more favorable in a case of being made into a flexographic printing plate, and the scratch resistance was also favorable.

In addition, from the comparison between Example 1 and Example 8, it was found that, in a case where the base polymer of the photosensitive resin layer was butadiene rubber, the microcell reproducibility was more favorable.

In addition, from the comparison between Examples 1, 7, and 9, it was found that, in a case where the molar ratio represented by Formula (i) was 65 to 75% by mole, the microcell reproducibility was more favorable in a case of being made into a flexographic printing plate, and the scratch resistance was also favorable.

Explanation of References

1: support
2: photosensitive resin layer
3: interlayer
4: infrared ablation layer
5: cover sheet
10: flexographic printing plate precursor

## Claims

**1.** A flexographic printing plate precursor comprising, in the following order:

a support;
a photosensitive resin layer;
an interlayer; and
an infrared ablation layer,
wherein the photosensitive resin layer contains a base polymer, water-dispersible particles, a photopolymerizable unsaturated compound, and a photopolymerization initiator, and
the interlayer contains a copolymer represented by Formula (1),

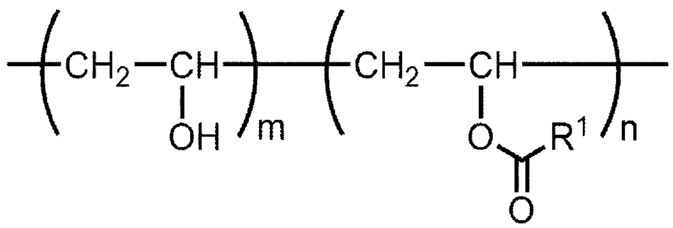
(1)

here, in Formula (1),

$R^1$ represents an alkyl group having 1 to 6 carbon atoms, and
m and n represent contents (% by mole) of each repeating unit, and a molar ratio represented by Formula (i) satisfies 60 to 75% by mole,

$$m/(m + n) \times 100 \qquad (i).$$

2. The flexographic printing plate precursor according to claim 1, wherein the base polymer is a diene-based rubber.

3. The flexographic printing plate precursor according to claim 1 or 2, wherein a content of the photopolymerization initiator is 1.5% by mass or more and less than 5.0% by mass with respect to a total solid content of the photosensitive resin layer.

4. The flexographic printing plate precursor according to claim 1 or 2, wherein a content of the water-dispersible particles is 10% by mass or more and less than 50% by mass with respect to a total solid content of the photosensitive resin layer.

5. The flexographic printing plate precursor according to claim 2, wherein the diene-based rubber is a butadiene rubber.

6. A manufacturing method of a flexographic printing plate having a non-image area and an image area, the manufacturing method comprising:

a mask forming step of, with respect to the flexographic printing plate precursor according to claim 1 or 2, forming an image on the infrared ablation layer included in the flexographic printing plate precursor to form a mask;
an exposure step of, after the mask forming step, imagewise exposing the photosensitive resin layer included in the flexographic printing plate precursor through the mask; and
a development step of, after the exposure step, performing development using a developer to form a non-image area and an image area.

FIG. 1

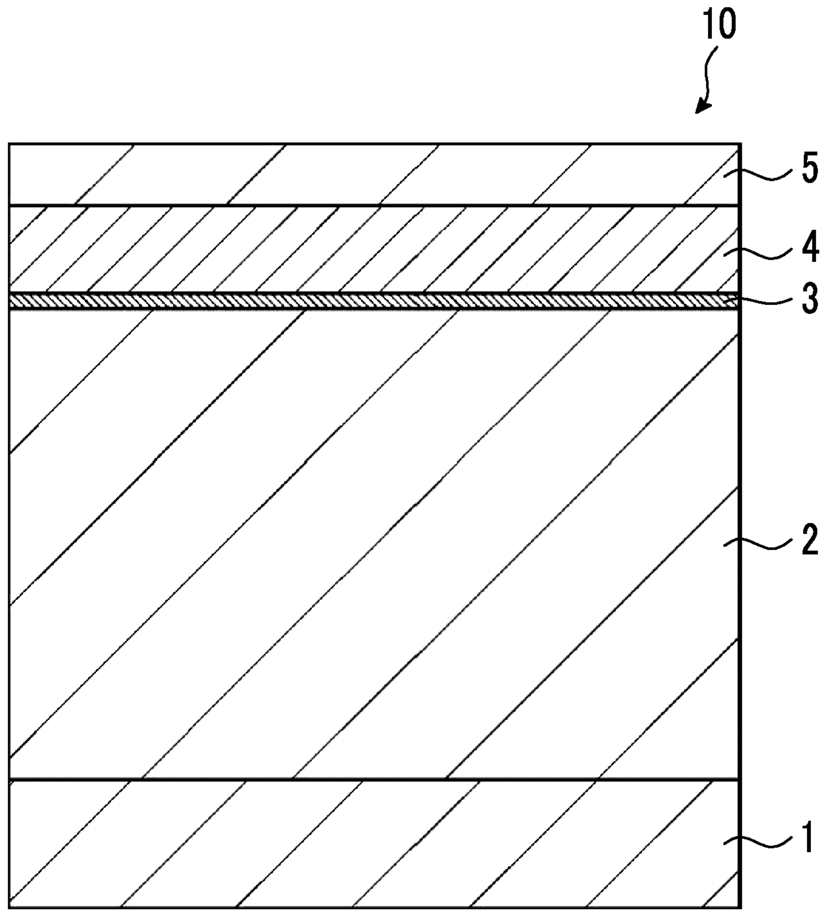

## INTERNATIONAL SEARCH REPORT

International application No. **PCT/JP2024/030369**

**A. CLASSIFICATION OF SUBJECT MATTER**

***G03F 7/00***(2006.01)i; ***B41C 1/05***(2006.01)i; ***B41N 1/00***(2006.01)i; ***G03F 7/004***(2006.01)i; ***G03F 7/11***(2006.01)i; ***G03F 7/033***(2006.01)i; ***G03F 7/095***(2006.01)i
FI: G03F7/00 502; G03F7/095; G03F7/033; G03F7/004 501; B41N1/00; B41C1/05; G03F7/11 502; G03F7/11 501

According to International Patent Classification (IPC) or to both national classification and IPC

**B. FIELDS SEARCHED**

Minimum documentation searched (classification system followed by classification symbols)

G03F7/00; B41C1/05; B41N1/00; G03F7/004; G03F7/11; G03F7/033; G03F7/095

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X<br><br>Y | WO 2011/013601 A1 (TOYOBO CO., LTD.) 03 February 2011 (2011-02-03)<br>claim 1 | 1-6<br><br>1-6 |
| X<br><br>Y | JP 2013-073179 A (TOKAI RUBBER INDUSTRIES, LTD.) 22 April 2013 (2013-04-22)<br>claims 6-7, examples | 1-6<br><br>1-6 |
| X<br><br>Y | JP 2014-160161 A (TOYOBO CO., LTD.) 04 September 2014 (2014-09-04)<br>claims 3, 5 | 1-6<br><br>1-6 |
| X<br><br>Y | WO 2022/173000 A1 (ASAHI KASEI KABUSHIKI KAISHA) 18 August 2022 (2022-08-18)<br>claim 18 | 1-6<br><br>1-6 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 October 2024** | **12 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/030369**

**C. DOCUMENTS CONSIDERED TO BE RELEVANT**

| Category* | Citation of document, with indication, where appropriate, of the relevant passages | Relevant to claim No. |
|---|---|---|
| Y | JP 2018-091953 A (ASAHI KASEI KABUSHIKI KAISHA) 14 June 2018 (2018-06-14) claims, example 2 | 1-6 |

Form PCT/ISA/210 (second sheet) (July 2022)

**INTERNATIONAL SEARCH REPORT**
**Information on patent family members**

International application No.
**PCT/JP2024/030369**

| Patent document cited in search report | Publication date (day/month/year) | Patent family member(s) | Publication date (day/month/year) |
|---|---|---|---|
| WO 2011/013601 A1 | 03 February 2011 | US 2012/0156514 A1<br>claim 1<br>EP 2461215 A1<br>CN 102472972 A | |
| JP 2013-073179 A | 22 April 2013 | (Family: none) | |
| JP 2014-160161 A | 04 September 2014 | (Family: none) | |
| WO 2022/173000 A1 | 18 August 2022 | EP 4183391 A1<br>claim 18<br>CN 114340608 A<br>TW 202206075 A | |
| JP 2018-091953 A | 14 June 2018 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- JP 2012137515 A
- WO 2009141930 A

### Non-patent literature cited in the description

- *JIS K 6726*, 1994